# EUROPEAN PATENT APPLICATION

(11) **EP 4 717 442 A1**
(43) Date of publication of application: **01.04.2026**
(21) Application number: 24203678.8
(22) Date of filing: 30.09.2024
(51) Int. Cl.: B29C 64/209, B33Y 30/00, F15D 1/02, H03H 9/02, B41J 2/025

(54) **APPARATUS AND METHOD FOR FLOW SCULPTING**

(71) Applicant: Technische Universität München, in Vertretung des Freistaats Bayern, 80333 München (DE)
(72) Inventor: Destgeer, Ghulam, 81827 München (DE); Sahin, Mehmet Akif, 80805 München (DE)
(74) Representative: Lucke, Andreas

(57) **Abstract**

An apparatus for sculpting flows of liquids in a flow channel comprises a piezoelectric material and an interdigitated electrode region. A pair of electrodes is arranged above the piezoelectric material. The electrodes are horizontally interdigitated in the interdigitated electrode region. The apparatus further comprises an acoustic wave stimulator adapted to stimulate an acoustic wave when excited via said pair of electrodes with an electrical excitation having a single frequency. The acoustic wave stimulator comprises at least a portion of the interdigitated electrodes in the interdigitated electrode region. The acoustic wave stimulator further comprises at least a portion of the piezoelectric material, said at least portion of the piezoelectric material underlying said at least portion of the interdigitated electrodes in the interdigitated electrode region. The apparatus further comprises a flow channel arranged above the interdigitated electrode region. Said flow channel defines a contiguous inner volume thereof and a flow direction for the flows of the liquids in the flow channel. The acoustic wave stimulator has an extension along a horizontal direction, said horizontal direction being perpendicular to the flow direction. The contiguous inner volume of the flow channel has an extension along said horizontal direction. According to a vertical projection onto a horizontal plane, said extension of the acoustic wave stimulator is fully comprised in said extension of the contiguous inner volume of the flow channel.

## Description

### FIELD OF THE DISCLOSURE

The present disclosure relates to an apparatus and a method for sculpting flows of liquids in a flow channel. Specifically, the present disclosure pertains to the use of piezoelectric materials and interdigitated electrodes to generate acoustic waves for precise control and manipulation of fluid flows, with applications including 3D printing technologies.

### BACKGROUND

In the field of fluid dynamics, it is common to manipulate and control the flow of liquids through various channels and conduits for applications ranging from industrial processes to biomedical devices. Known systems typically involve mechanical components such as valves, pumps, and barriers to direct and regulate fluid flow. These mechanical systems, while effective, often suffer from limitations including wear and tear, mechanical failure, and the need for regular maintenance. Additionally, the precision with which these systems can control fluid flows is often limited by the mechanical nature of their operation.

### SUMMARY OF THE DISCLOSURE

Despite the substantial advances in the field of fluid flow manipulation and flow sculpting, there remains a need for faster, more efficient, precise, and reliable methods to control liquid flows in various applications.

It is thus an object of this invention to provide an apparatus that overcomes one or more of the disadvantages of known systems.

According to a first aspect, an apparatus for sculpting flows of liquids in a flow channel is provided. The apparatus comprises a piezoelectric material and an interdigitated electrode region. A pair of electrodes is arranged above the piezoelectric material. The electrodes are horizontally interdigitated in the interdigitated electrode region. The apparatus further comprises an acoustic wave stimulator adapted to stimulate an acoustic wave when excited via said pair of electrodes with an electrical excitation having a single frequency. The acoustic wave stimulator comprises at least a portion of the interdigitated electrodes in the interdigitated electrode region. The acoustic wave stimulator further comprises at least a portion of the piezoelectric material, said at least portion of the piezoelectric material underlying said at least portion of the interdigitated electrodes in the interdigitated electrode region. The apparatus further comprises a flow channel arranged above the interdigitated electrode region. Said flow channel defines a contiguous inner volume thereof and a flow direction for the flows of the liquids in the flow channel. The acoustic wave stimulator has an extension along a horizontal direction, said horizontal direction being perpendicular to the flow direction. The contiguous inner volume of the flow channel has an extension along said horizontal direction. According to a vertical projection onto a horizontal plane, said extension of the acoustic wave stimulator is fully comprised in said extension of the contiguous inner volume of the flow channel.

A respective apparatus, via the acoustic wave generated by the acoustic wave stimulator, can actively sculpt the flows of the liquids in the flow channel, for example in terms of their cross-sections in planes perpendicular to the flow direction. A wide variety of cross-sections of the flows of the liquids in the flow channel can be generated. In particular, the apparatus permits to apply an electrical excitation with a tailored amplitude, frequency and/or time of envelope to achieve any desired, specific cross-sections of the flows of the liquids in the flow channel from said wide variety of cross-sections.

The sculpting of the flows using the acoustic wave stimulator can be modified or changed much faster than the sculpting of flows in conventional flow sculpting apparatus, which apply macroscopic mechanical objects such as valves or other forms of flow obstacles and the movement thereof to achieve the sculpting of the flows. In said conventional apparatus, any modification to the sculpting of the flows requires a movement of said macroscopic mechanical objects, which is slow in comparison to changing the electrical excitation and hence the acoustic wave in the apparatus according to this description.

Without wishing to be bound by any theory, the applicant believes that the forces sculpting the cross-sections of the flows of the liquids in the flow channel increase with the gradient of the acoustic wave generated by the acoustic wave stimulator.

As in the apparatus according to this disclosure, the extension of the acoustic wave stimulator is fully comprised in the extension of the contiguous inner volume of the flow channel, gradients of said acoustic wave, and thus forces sculpting the cross-sections of the flows of the liquids in the flow channel, can be achieved having either orientation with respect to the horizontal direction of the claim (e.g., "left" and "right", or "along" or "opposite to" said horizontal direction, respectively). This is a major advantage over conventional apparatus, wherein the acoustic wave stimulator is located displaced from the flow channel or covers the entire horizontal extension of the flow channel. In those conventional apparatus, acoustic wave gradients and thus forces can only be achieved in one direction along said horizontal direction (e.g., only "left" or only "right") or no acoustic wave gradients can be achieved at all along said horizontal direction, as the acoustic wave is generated along the entire extension of the contiguous inner volume of the flow channel.

The wide variety of cross-sections of the flows of the liquids in the flow channel that can be generated with the apparatus according to this disclosure is an immediate consequence of the possibility to achieve gradients of said acoustic wave having either orientation with respect to the horizontal direction of the claim. For example, the apparatus according to this disclosure permits to "bend" a flow of liquid in the flow channel around a curve along the flow direction through the center of the flow channel, resulting in the generation of a hollow fiber. This is not possible with conventional apparatus providing gradients along with one orientation along said horizontal direction.

The piezoelectric material is a material that generates an electric charge in response to mechanical stress. This feature is advantageous because it allows the apparatus to convert electrical signals into mechanical vibrations, which are essential for generating acoustic waves. The pair of electrodes is arranged above the piezoelectric material and is horizontally interdigitated. This arrangement ensures that the electric field generated by the electrodes is effectively coupled with the piezoelectric material, thereby optimizing the generation of acoustic waves.

The interdigitated electrode region consists of electrodes that are interlocked in a comb-like structure. This configuration is beneficial as it enhances the efficiency of the acoustic wave generation by providing a larger interaction area between the electrodes and the piezoelectric material.

According to an embodiment, the flow channel comprises opposite side walls separating the contiguous inner volume of the flow channel from an outside of the flow channel. The contiguous inner volume of the flow channel extends continuously from one of said opposite side walls to an opposite one of said opposite side walls, in particular without any flow obstacle in between.

In other words, no flow obstacles (such as internal walls or constrictions of the flow channel, valves, or changes in the cross section of the channel) are needed to sculpt the flow with the apparatus according to the description.

In yet other words, the apparatus according to the description achieves an efficient and precise sculpting of the flows of the liquids in the flow channel using the acoustic wave stimulator. This is particularly beneficial, since the generated acoustic wave can be modified quickly, without a need to adjust a mechanical part of the apparatus such as a valve for an arrangement of a flow obstacle. Hence, the acoustic wave and the resulting shape of the sculpted flows can be changed while the flows of the liquids pass through the flow channel, thus sculpting the flows not only in the plane perpendicular to the flow direction, but also along the flow direction. In other words, the apparatus permits a three-dimensional sculpting or shaping of the flows.

The absence of flow obstacles also reduces the flow resistance of the flow channel, thus increasing the flow rate and the throughput of the apparatus.

The contiguous inner volume of the flow channel may have said extension from one of the opposite side walls to the opposite one of the opposite side walls in a vertical plane perpendicular to the flow direction; preferably, in a plurality of vertical planes perpendicular to the flow direction, said vertical planes may be spaced apart along the flow direction from each other by a distance exceeding said extension of the acoustic wave stimulator or exceeding said extension of the contiguous inner volume of the flow channel.

According to an embodiment, a total length of the acoustic wave stimulator along the flow direction is at least as large as the extension of the acoustic wave stimulator along said horizontal direction. A total length of the acoustic wave stimulator along the flow direction may be at least three times or at least five times as large as the extension of the respective acoustic wave stimulator along said horizontal direction.

In particular, the total length may refer to the length along the flow direction of a single acoustic wave stimulator according to the first aspect or the apparatus may comprise a plurality of respective acoustic wave stimulators, and the total length may refer to the sum of the lengths of said acoustic wave stimulators along the flow direction. In some embodiments, the acoustic wave stimulators of the plurality of respective acoustic wave stimulators are located at different positions along the flow direction.

A respective length is beneficial to allow for adjusting the electrical excitation and hence the generated acoustic wave while the flows of the liquids are passing through the flow channel above the acoustic wave stimulator. More specifically, with a respective length of the acoustic wave stimulator, the electrical excitation and/or the generated acoustic wave can be modified such that a sub-volume of the liquid (the sub-volume serving merely as a reference, without being separate or different from the rest of the liquid) such as a probe volume much smaller than the overall volume of the liquid, experiences a varying acoustic wave and hence a varying force as it flows above the acoustic wave stimulator through the flow channel. Thus, the respective length beneficially promotes the sculpting of the flows not only in the plane perpendicular to the flow direction, but also along the flow direction as described above. In other words, the feature beneficially supports the three-dimensional sculpting or shaping of the flows.

Notably, a single acoustic wave stimulator may be provided having said total length, or the total length may be distributed over several acoustic wave stimulators, posing two alternative ways to provide the total length to support sculpting of the flows along the flow direction. Having several acoustic wave stimulators may be advantages in some situations, since electrical excitations can be provided to the respective acoustic wave stimulators individually, giving additional control over the sculpting of the flows.

According to an embodiment, the apparatus further comprises an electrical excitation unit adapted to provide said electrical excitation via the electrodes to the acoustic wave stimulator to drive the acoustic wave stimulator to stimulate said acoustic wave.

In respective embodiments, the electrical excitation unit may be adapted to provide the electrical excitation with a varying amplitude, such that, as the flows of the liquids in the flow channel pass flowing above the acoustic wave stimulator, they are exposed to said acoustic wave while the acoustic wave has a varying amplitude. In particular, the varying amplitude may refer to a time-varying amplitude and/or to a spatially varying amplitude, in particular a spatially varying amplitude as a sub-volume of the flows of the liquids in the flow channel passes flowing above the acoustic wave stimulator along the flow direction.

This adaptation further improves the sculpting of the flows along the flow direction.

According to an embodiment, the apparatus further comprises an intermediate element arranged between the piezoelectric material and the flow channel.

The intermediate element serves as a structural component that may provide additional support and stability to the apparatus, and/or may improve adhesion of the flow channel to the rest of the apparatus, in particular to the acoustic wave stimulator and/or to the piezoelectric material. The intermediate element may facilitate the mechanical integration of the piezoelectric material and the flow channel, ensuring that the flow channel remains properly aligned and secured during operation.

The intermediate element may be adapted to, in particular arranged to and/or shaped to, mechanically support a section of the flow channel not arranged directly above the interdigitated electrode region.

This adaptation may involve shaping or positioning the intermediate element to ensure that unsupported sections of the flow channel are adequately supported, thereby preventing sagging or deformation. The mechanical support provided by the intermediate element may help maintain the structural integrity and proper functioning of the flow channel.

Alternatively, or in addition, the intermediate element may have a larger thickness along the vertical direction at a position not directly above the interdigitated electrodes in the interdigitated electrode region than above the interdigitated electrodes in the interdigitated electrode region, in particular, including a thickness of zero, or an absence, respectively, of the intermediate element above the interdigitated electrodes in the interdigitated electrode region.

Alternatively, or in addition, the intermediate element may be arranged at a larger distance from a vertical plane extending along the flow direction through a center of the flow channel than the interdigitated electrode region.

Alternatively, or in addition, the intermediate element may be an adhesion layer to promote adhesion of the flow channel to another component of the apparatus, in particular to the piezoelectric material and/or to the acoustic wave stimulator.

In respective embodiments, the intermediate element enhances the bonding between the flow channel and other components of the apparatus, such as the piezoelectric material or the acoustic wave stimulator. The adhesion layer may improve the mechanical stability and integrity of the apparatus, ensuring that the components remain securely attached during operation. This enhanced adhesion may also contribute to the efficient transmission of acoustic waves and to the overall performance of the apparatus.

Alternatively, or in addition, the intermediate element may be an intermediate layer.

Alternatively, or in addition, the intermediate element may comprise or be composed of a polymer.

The flow channel may comprise or may be composed of a polymer such as polydimethylsiloxane. In alternative embodiments, the flow channel comprises or is composed of a glass.

The use of a polymer may offer several advantages, such as flexibility, durability, and ease of fabrication. The polymer composition of the intermediate element may enhance its ability to provide mechanical support, adhesion, and other functional benefits within the apparatus. The choice of polymer material may be tailored to meet the specific requirements of the apparatus, ensuring optimal performance and reliability.

According to an embodiment, the acoustic wave stimulated by the acoustic wave stimulator is a surface acoustic wave, in particular on a surface of the acoustic wave stimulator and/or on an inner surface of the flow channel.

Alternatively, or in addition, the flows of liquids in the flow channel may be parallel flows of liquids in the flow channel.

According to some embodiments, the electrodes of the pair of electrodes being horizontally interdigitated refer to each electrode of the pair of electrodes comprising or being finger electrodes, wherein a vertical plane parallel to the flow direction intersects each of said finger electrodes of each of the electrodes of the pair of electrodes and/or wherein a line parallel to the flow direction intersects each of said finger electrodes of each of the electrodes of the pair of electrodes.

Alternatively, or in addition, the electrodes of the pair of electrodes may be electrically connected and/or directly connected to the piezoelectric material in the interdigitated electrode region.

Respective embodiments improve the efficiency of the acoustic wave generation by ensuring better transmission of the electrical excitation to the piezoelectric material.

Alternatively, or in addition, for each electrode of the pair of electrodes a vertical reference line may exist intersecting both the piezoelectric material and the respective electrode of the pair of electrodes.

Alternatively, or in addition, the electrodes may comprise or may consist of an electrically conductive material, in particular of a metal.

This choice of material may enhance the electrical conductivity and durability of the electrodes.

Alternatively, or in addition, the single frequency may be in a range from 1 MHz to 1 GHz.

Respective frequencies are transmitted sufficiently well in fluids to allow for shaping of the flows along the vertical direction of the channel, and on the other hand are sufficiently dampened in the fluids to implement an acoustic wave gradient sufficient to generate significant force for sculpting the flows of the liquids in the fluid channel.

Alternatively, or in addition, the electrodes in the interdigitated electrode region may extend along a horizontal plane and/or may all be intersected by a single horizontal plane.

Alternatively, or in addition, the vertical projection may refer to a projection along the vertical direction.

According to an embodiment, each electrode of the pair of electrodes comprises finger electrodes, the finger electrodes of both of the electrodes of the pair of electrodes being parallel in the interdigitated electrode region.

In particular, the finger electrodes may form the interdigitated electrodes in the interdigitated electrode region.

Alternatively, or in addition, the finger electrodes may be spaced equidistantly along said horizontal direction.

This ensures that the acoustic wave is efficiently generated with the electrical excitation having the single frequency.

Alternatively, or in addition, the finger electrodes of the electrodes of the pair of electrodes may be arranged alternatingly along said horizontal direction, in particular such that for each finger electrode of one of the electrodes of the pair of electrodes at least one neighboring finger electrode exists, the neighboring finger electrode being a finger electrode of the other electrode of the pair of electrodes.

This ensures that the acoustic wave is efficiently generated with the electrical excitation having the single frequency.

According to an embodiment, the apparatus comprises a plurality of interdigitated electrode regions comprising said interdigitated electrode region, each interdigitated electrode region of the plurality of interdigitated electrode regions being an interdigitated electrode region as described above in the context of the embodiment, wherein each electrode of the pair comprises finger electrodes, the finger electrodes of both of the electrodes of the pair of electrodes being parallel in the interdigitated electrode region. In respective embodiments, the apparatus may further comprise a plurality of pairs of electrodes comprising said pair of electrodes, each pair of electrodes from the plurality of pairs of electrodes associated with a corresponding interdigitated electrode region from the plurality of interdigitated electrode regions, the electrodes of each pair of electrodes being arranged above the piezoelectric material and being horizontally interdigitated in the associated interdigitated electrode region. In respective embodiments, the apparatus may further comprise a plurality of acoustic wave stimulators comprising said acoustic wave stimulator, each of said acoustic wave stimulators associated with a corresponding interdigitated electrode region and with the pair of electrodes associated with the respective associated interdigitated electrode region, each of said acoustic wave stimulators being adapted to stimulate an acoustic wave when excited via the associated pair of electrodes with an electrical excitation having a single frequency, each of the acoustic wave stimulators comprising at least a portion of the interdigitated electrodes of the associated pair of electrodes in the associated interdigitated electrode region, and further comprising at least a portion of the piezoelectric material, said at least one portion of the piezoelectric material underlying said at least one portion of the interdigitated electrodes of the associated pair of electrodes in the associated interdigitated electrode region. In respective embodiments, according to a vertical projection onto a horizontal plane, an extension of each of the acoustic wave stimulators may be fully comprised in said extension of the contiguous inner volume of the flow channel. In respective embodiments, the interdigitated electrode regions of the plurality of interdigitated electrode regions may be arranged at different positions with respect to said horizontal direction.

According to an embodiment, a distance between the interdigitated electrodes in the interdigitated electrode region varies along said horizontal direction.

The efficiency of exciting of an acoustic wave using the acoustic wave stimulator according to the current description depends strongly on the frequency of the electrical excitation in relation to the resonance frequency of said acoustic wave stimulator. The resonance frequency of the acoustic wave stimulator depends on the distance between the interdigitated electrodes. A larger distance between the interdigitated electrodes results in a lower resonance frequency of the acoustic wave stimulator, and vice versa. Hence, in embodiments with the varying distance between the interdigitated electrodes along said horizontal direction, the resonance frequency determined by the interdigitated electrodes in the interdigitated electrode region, or by the distance between them, respectively, varies along said horizontal direction. In other words, when an electrical excitation is provided with a frequency, such as a frequency distribution or a single frequency, it selectively excites that subregion of the interdigitated electrode region to generate acoustic waves, for which the frequency of the electrical excitation matches (or is sufficiently close to) the resonance frequency. The respective subregion of the interdigitated electrode region thus serves as the acoustic wave stimulator. Other regions of the interdigitated electrode region, whose resonance frequency is different from the frequency of the electrical excitation, are not efficiently excited by the electrical excitation and do not efficiently generate acoustic waves. Those other regions of the interdigitated electrode region do not serve as an acoustic wave stimulator in view of the excitation having said frequency.

Hence, in respective embodiments, an acoustic wave stimulator can be selected as a subregion of the interdigitated electrode region by selecting the frequency of the electrical excitation to match the resonance frequency of the respective subregion of the interdigitated electrode region. Only the respective subregion of the interdigitated electrode region poses the acoustic wave stimulator.

For example, respective embodiments allow for dynamically moving around the acoustic wave stimulator within the interdigitated electrode region by making changes to the frequency of the electrical excitation. This allows for achieving an even wider variety of shapes of the sculpted flows of the fluids.

In respective embodiments, each electrode of the pair of electrodes may comprise finger electrodes, the finger electrodes of one of the electrodes of the pair of electrodes forming the interdigitated electrodes in the interdigitated electrode region together with the finger electrodes of the other electrode of the pair of electrodes. In particular, the distance between the interdigitated electrodes in the interdigitated electrode region may refer to a distance between the finger electrodes of one of the electrodes of the pair of electrodes and the finger electrodes of the other electrode of the pair of electrodes.

Alternatively, or in addition, the distance between the interdigitated electrodes in the interdigitated electrode region may vary monotonically along said horizontal direction.

Alternatively, or in addition, the distance between the interdigitated electrodes in the interdigitated electrode region may vary along said horizontal direction in a stepwise manner or continuously.

According to an embodiment, the apparatus further comprises a parallel flow generator adapted to provide the flows of liquids in the flow channel as parallel flows of liquids, the parallel flow generator comprising additional flow channels, each of said additional flow channels fluid-connected to the flow channel upstream of the acoustic wave stimulator.

The parallel flow generator allows to provide the flows of the fluids in the flow channel in a controlled and well-defined manner, namely, as parallel flows, thus giving well-defined initial conditions for the sculpting of the flows, improving the overall the reliability and accuracy of the sculpting. For example, the parallel flows maybe continuous along the flow direction, allowing for the sculpting of said parallel flows into fibers with a wide variety of cross-sectional shapes. Alternatively, the parallel flows of the fluids may be divided along the flow direction, for example using a conventional IDT structure, into shorter segments, and those shorter segments may be sculpted into particles with a wide variety of shapes using the apparatus according to this disclosure. Yet alternatively, the parallel flow generator may provide the flows of the fluids as continuous parallel flows, and said continuous parallel flows are divided into shorter segments during the sculpting of the flows using the apparatus according to this disclosure.

In respective embodiments, each of said additional flow channels may be adapted to provide a corresponding one of the flows of the liquids to the flow channel.

Alternatively, or in addition, the additional flow channels may be fluid-connected to the flow channel upstream of the acoustic wave stimulator such that flows of fluids provided to the flow channel from the additional flow channels are hydrodynamically focused into the flow channel.

The parallel flows of liquids may be stacked vertically above one another or may be at least in part stacked vertically above one another.

The parallel flows of liquids may be stacked side by side to each other along said horizontal direction, or may be at least in part stacked side by side to each other along said horizontal direction.

Hydrodynamic focusing ensures that the liquid streams are aligned and concentrated as they enter the main flow channel.

According to an embodiment, the apparatus further comprises a lithographic mask arranged in a lithographic masking section of the apparatus, the lithographic masking section arranged downstream of the acoustic wave stimulator, wherein a section of the flow channel passes through said lithographic masking section. In respective embodiments, the lithographic mask is arranged in the lithographic masking section such that, under illumination of the lithographic mask with a UV radiation having a direction towards said section of the flow channel, said UV radiation is masked with the lithographic mask before reaching said section of the flow channel.

In respective embodiments, at least one of the liquids may comprise a chemical component suitable to be cured or hardened under illumination with UV radiation, or at least two of the liquids may comprise respective chemical components suitable to be cured or hardened under illumination with UV radiation.

Respective embodiments allow for curing at least some of said chemical components comprised in the liquids, thus supporting the formation of solid structures from the sculpted flows, the shapes of the solid structures reflecting the shapes of the sculpted flows as achieved by the flow sculpting according to this disclosure.

The lithographic mask may comprise slits having segments with an extension perpendicular to a flow direction in the lithographic masking section, said slits being adapted to allow said UV radiation to reach said section of the channel. In respective embodiments, the lithographic mask may be adapted to block at least a part of the UV radiation or the UV radiation not passing through the slits.

According to an embodiment, the apparatus further comprises a UV source adapted to provide the UV radiation having the direction towards said section of the flow channel.

Alternatively, or in addition, said section of the flow channel may be permeable to oxygen.

Respective embodiments promote the formation of an oxidized layer at the surface of the cured or hardened chemical components, or of the resulting solid, respectively, thus reducing the risk that they stick to the inside wall of the flow channel, thus reducing the risk of clogging.

According to a second aspect, a print head for 3D printing is provided. The print head comprises an outlet nozzle. The print head comprises an apparatus according to any of the embodiments described above. An outlet of the flow channel is fluid-connected to said outlet nozzle of the print head, such that the print head is adapted to provide at its outlet nozzle the output of said outlet of the flow channel.

A respective print head allows for 3D-printing the output of the apparatus, i.e., 3D-printing a wide variety of multicomponent materials with controllable cross-sections, such as fibers or particles with controllable cross-sections comprising more than one component.

According to a third aspect, a method for flow sculpting is provided. The method comprises providing the apparatus or the print head according to any of the embodiments described above. The method further comprises providing the flows of the liquids in the flow channel of the apparatus as parallel flows of fluids in the flow channel upstream of the acoustic wave stimulator of the apparatus. The method further comprises applying an electrical excitation to the acoustic wave stimulator via the pair of electrodes to stimulate the acoustic wave, thus sculpting the flows of the fluids in the flow channel.

According to an embodiment, the fluids comprise a common solvent or the fluids are miscible. In particular, the fluids may be partially miscible or the fluids may be fully miscible or the fluids may be partially miscible co-flowing fluids with negligible interfacial tension.

Providing the flows of the liquids in the flow channel of the apparatus as parallel flows of fluids in the flow channel upstream of the acoustic wave stimulator of the apparatus may comprise hydrodynamically focusing flows of liquids from additional flow channels fluid-connected to the flow channel upstream of the acoustic wave stimulator into the flow channel.

This ensures a good contact between the sections comprising different materials in a solid part being ultimately fabricated.

According to an embodiment, the electrical excitation is said electrical excitation having the single frequency, wherein, when excited via said pair of electrodes with the electrical excitation having said single frequency, only a portion of the interdigitated electrodes in the interdigitated electrode region and the piezoelectric material underlying said only portion of the interdigitated electrodes stimulates the acoustic wave, said only portion of the interdigitated electrodes in the interdigitated electrode region having an extension along said horizontal direction, and wherein, according to a vertical projection onto a horizontal plane, said extension of said only portion of the interdigitated electrodes in the interdigitated electrode region is smaller than an extension of the interdigitated electrodes (26) in the interdigitated electrode region (20) along said horizontal direction, in particular at least by a factor of 1.5 or at least by a factor of 2.

According to some embodiments, the electrical excitation is applied using the electrical excitation unit described above.

According to some embodiments, the flows of the liquids in the flow channel of the apparatus are provided as parallel flows of fluids in the flow channel upstream of the acoustic wave stimulator of the apparatus using the parallel flow generator described above.

According to some embodiments at least one of the liquids comprises a chemical component suitable to be cured or hardened under illumination with UV radiation, or at least two of the liquids comprise respective chemical components suitable to be cured or hardened under illumination with UV radiation. In respective embodiments, the method may further comprise curing said chemical component(s) using UV radiation.

Said curing of the chemical component(s) using UV radiation may comprise illuminating the liquid(s) in the flow channel comprising said chemical component(s) with UV radiation.

In respective embodiments, the method may further comprise a masking of said UV radiation. The masking may use a lithographic mask as described above.

Illuminating the liquid(s) in the flow channel may use a UV source as described above.

### LIST OF FIGURES

In the following, a detailed description of the present disclosure and examples thereof is given with reference to the figures. The figures show schematic illustrations of
Fig. 1a and Fig. 1b: an apparatus according to a first embodiment of the present disclosure;
Fig. 2a and Fig. 2b the interdigitated electrode region of the apparatus according to an embodiment;
Fig. 3a and Fig. 3b: an apparatus according to another embodiment of the present disclosure;
Fig. 4a and Fig. 4b: an apparatus according to another embodiment of the present disclosure;
Fig. 5a, Fig. 5b and Fig. 5c: the sculpting of the flows according to an embodiment of the present disclosure;
Fig. 6a and Fig. 6b: an apparatus according to another embodiment of the present disclosure;
Fig. 7: an apparatus according to another embodiment of the present disclosure;
Fig. 8a, Fig. 8b and Fig. 8c: the sculpting of the flows according to some embodiments of the present disclosure;
Fig. 9: an apparatus according to another embodiment of the present disclosure;
Fig. 10: an apparatus according to another embodiment of the present disclosure;
Fig. 11: a print head according to an embodiment of the present disclosure;
Fig. 12a: a cross section through the print head according to the embodiment of Fig. 11;
Fig. 12b: the print head according to the embodiment of Fig. 11 according to a projection along the z direction onto an x-y plane;
Fig. 13: an apparatus according to another embodiment of the present disclosure; and
Fig. 14: a method according to an embodiment of the present disclosure.

### DESCRIPTION OF EXAMPLES

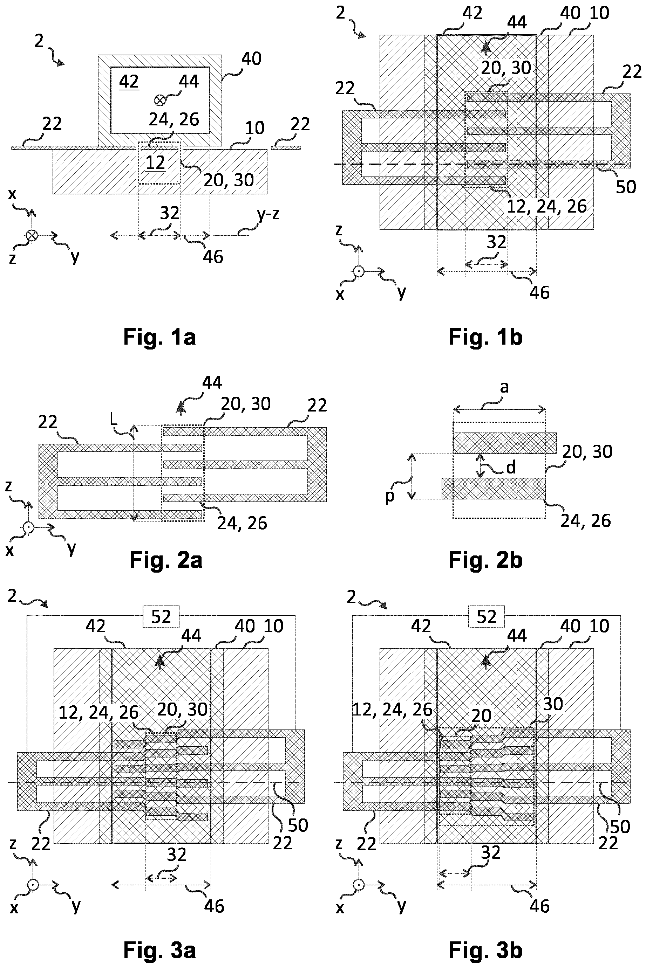

Fig. 1a and Fig. 1b illustrate an apparatus 2 for sculpting flows of liquids 58a, 58b, 58c in a flow channel 40 according to a first embodiment.

Further, a coordinate system is given in Fig. 1a and Fig. 1b. Said coordinate system serves as a reference, but does not add any physical structure to the apparatus 2. In the following, reference is made to the x, y, z directions of the coordinate system, with the x-axis being referred to as the vertical axis, and the y-z-plane being referred to as a horizontal plane. This reference frame serves to indicate the arrangement of the components relative to each other, it does not imply an orientation of the overall apparatus 2 with respect to an external reference frame. In other words, the overall apparatus 2 may be rotated with respect to the orientations depicted in the figures. In this case, the coordinate system and the vertical/horizontal direction(s) are to be rotated together with the apparatus 2.

The cross-sectional view of Fig. 1a refers to a cross section with respect to a vertical x-y plane intersecting Fig. 1b at the position indicated by line 50.

The apparatus 2 comprises a piezoelectric material 10.

In the depicted embodiment, the piezoelectric material 10 is lithium niobate, but other piezoelectric materials 10 may alternatively be applied, including crystalline, ceramic, or polymeric piezoelectric materials. Piezoelectric materials 10 may be applied such as lead zirconate titanate, barium titanate, quartz, zinc oxide, aluminum nitride, lithium niobate, lithium tantalate, sodium potassium niobate, potassium sodium niobate, gallium orthophosphate, polyvinylidene fluoride, potassium niobate, sodium niobate, lanthanum gallium silicate, berlinite, tourmaline, langasite, bismuth ferrite, gallium nitride, barium strontium titanate, cesium nitrate, Rochelle salt, lead magnesium niobate, sodium bismuth titanate, potassium niobium oxide, lead titanate.

In the depicted embodiment, the piezoelectric material 10 is provided in the form of a substrate mechanically supporting the rest of the apparatus 2. In alternative embodiments (not shown), the piezoelectric material 10 is provided in the form of a thin-film coated onto a substrate made from a different material.

The apparatus 2 further comprises a pair of electrodes 22 arranged above the piezoelectric material 10. In the depicted embodiment, the electrodes 22 are formed by depositing a layer comprising chromium and titanium onto the piezoelectric material 10 through a stencil mask having openings reflecting the shapes of the electrodes 22 to be produced. Thereafter, a layer of aluminum or gold is deposited above said layer comprising the chromium and titanium using the same stencil mask. In alternative embodiments, the electrodes 22 are produced from other electrically conductive or metallic materials. In some embodiments, to form the electrodes 22, a layer of the metallic materials is first deposited as a continuous layer and then parts of the continuous layer are etched to give the electrodes 22 their shapes.

The electrodes 22 thus have the shape of a structured layer, or they extend along a horizontal y-z-plane, respectively.

The apparatus 2 further comprises an interdigitated electrode region 20. In the interdigitated electrode region 20, the electrodes 22 are horizontally interdigitated. For this reason, in the context of this disclosure, the electrodes 22 in the interdigitated electrode region 20 are referred to as interdigitated electrodes 26. The interdigitated electrode region 20 serves as a reference region, and does not add physical structure to the apparatus 2.

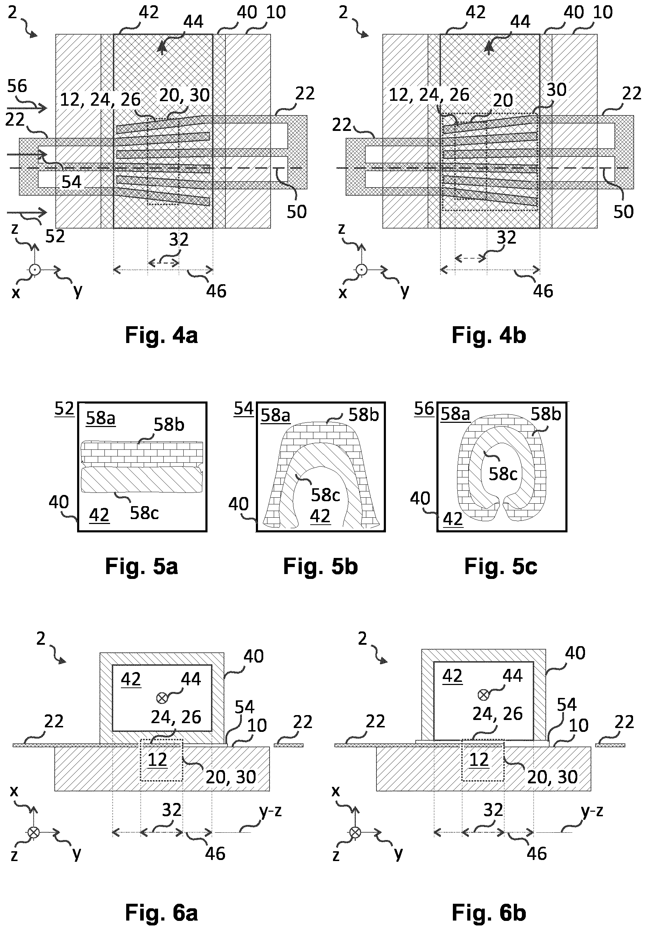

The apparatus 2 further comprises an acoustic wave stimulator 30 adapted to stimulate an acoustic wave when excited via said pair of electrodes 22 with an electrical excitation having a single frequency f. In the depicted embodiment, said acoustic wave stimulator 30 is formed by the interdigitated electrodes 26 in the interdigitated electrode region 20 and at least part of the piezoelectric material 10. In alternative embodiments, as will be described in detail below in the context of Fig. 3a, Fig. 3b, Fig. 4a, and Fig. 4b the acoustic wave stimulator 30 is formed by only part of the interdigitated electrodes 26 in the interdigitated electrode region 20, and part of the piezoelectric material 10.

When an electrical excitation, such as a periodically varying voltage with a frequency f, is applied to the electrodes 22, the acoustic wave stimulator 30 generates a surface acoustic wave (SAW) by converting the electrical excitation into mechanical stress in the piezoelectric material 10 via the piezoelectric effect thereof. The alternating electric field between the interdigitated electrodes 26, which results from the varying voltage applied to the electrodes 22, causes the piezoelectric material 10 to deform, producing mechanical vibrations at the surface of the piezoelectric material 10. These vibrations emerge and propagate as SAWs. The type of acoustic wave stimulator 30 applied in the embodiment of Fig. 1a, Fig. 1b is also referred to as an Interdigitated Transducer (IDT) 30.

The apparatus 2 further comprises a flow channel 40 arranged above the interdigitated electrode region 20. The flow channel 40 defines a contiguous inner volume 42 thereof. The flow channel 40 further defines a flow direction 44, z for the flows of the liquids 58a, 58b, 58c in the flow channel 40.

The flow channel 40 comprises channel walls to define the contiguous inner volume 42 and the flow direction 44, z for the flows of the liquids 58a, 58b, 58c. In the depicted embodiment, the flow channel 40 comprises, or said channel walls comprise, respectively side walls, a top wall, and a bottom wall.

In other words, the flow channel 40 is a tube extending along the flow direction 44, z enclosing the contiguous inner volume 42 in an x-y-plane perpendicular to the flow direction 44, z.

In the depicted embodiment, the flow channel 40, or said tube, respectively, has a rectangular inner cross-section. In alternative embodiments (not shown), the inner cross-section is quadratic or circular or elliptical or U-shaped.

In the depicted embodiment, the flow channel 40, or the channel walls, respectively, are initially fabricated separate from the acoustic wave stimulator 30. In the depicted embodiment, the flow channel 40, or the channel walls, respectively, is/are formed from polydimethylsiloxane, but in alternative embodiments, the flow channel 40 is formed from a different polymer or of from a glass.

In the depicted embodiment, the flow channel 40 is fabricated separate from the acoustic wave stimulator 30 as an integral piece comprising the side walls, the top wall, and the bottom wall. In alternative embodiments, as will be described in more detail in the context of Fig. 6b, the flow channel 40 is fabricated separate from the acoustic wave stimulator 30 as an integral piece having only some of said channel walls, and part of the final flow channel 40 is provided by a different part or different parts of the apparatus 2, for example by the intermediate element 54 and/or by the acoustic wave stimulator 30 and/or by the piezoelectric material 10.

In alternative embodiments, the flow channel 40 is fabricated over/above the acoustic wave stimulator 30 using an additive manufacturing technique such as 3D printing.

The acoustic wave stimulator 30, which, in the embodiment of Fig. 1a, Fig. 1b is identical to the interdigitated electrodes 26 in the interdigitated electrode region 20 and the underlying piezoelectric material 10, has an extension 32 along the horizontal direction y perpendicular to the flow direction 44, z.

The contiguous inner volume 42 of the flow channel 40 has an extension 46 along the horizontal direction y perpendicular to the flow direction 44, z.

As indicated in Fig. 1a, said extension 32 of the acoustic wave stimulator 30 is fully comprised in said extension 46 of the contiguous inner volume 42 of the flow channel 40 according to a vertical projection, i.e., along the vertical direction x, onto the horizontal y-z plane.

This may, according to a possible definition, mean that a section of the contiguous inner volume 42 of the flow channel 40 exists, which, when vertically projected onto the horizontal y-y plane, is identical to the vertical projection of the acoustic wave stimulator 30 onto the horizontal y-z plane, and that the inner volume 42 of the flow channel 40 is wider than said section of the contiguous inner volume 42, for example by at least 20% of said extension 32 of the acoustic wave stimulator 30 or by at least 50% of said extension 32 of the acoustic wave stimulator 30. In some embodiments, the inner volume 42 of the flow channel 40 is wider than said section of the contiguous inner volume 42 by at least by a factor of 2 or at least by a factor of 3 or at least by a factor of 5.

Since the extension 32 of the acoustic wave stimulator 30 is fully comprised in said extension of the contiguous inner volume 42 of the flow channel 40, the acoustic wave produced by the acoustic wave stimulator 30 has its largest amplitude, for example in terms of a pressure amplitude, at a position along the horizontal direction y within the contiguous inner volume 42 of the flow channel 40, namely above the acoustic wave stimulator 30. In other words, the amplitude, for example the pressure amplitude, of the generated acoustic wave decreases within the inner volume 42 of the flow channel 40 along the horizontal direction y away from the position above the acoustic wave stimulator 30, both to the left and to the right in Fig. 1a, Fig. 1b. In yet other words, amplitude gradients of the acoustic wave, or pressure gradients, respectively, are generated within the contiguous inner volume 42 of the flow channel 40 both along the +y direction, namely to the right-hand side of the position of above the acoustic wave stimulator 30, and along the -y direction, namely to the left-hand side of the position of above the acoustic wave stimulator 30.

Hence, the apparatus 2 with the acoustic wave stimulator 30 according to this disclosure gives full control over the amplitude gradient, or over the pressure gradient, respectively, in the inner volume 42 of the flow channel 40.

Notably, regarding the x-component of the amplitude gradient, or of the pressure gradient, respectively, said x-component is always directed upwards in the embodiment of Fig. 1a,

Fig. 1b. However, in a modified embodiment (not shown), an additional acoustic wave stimulator (not shown) is arranged above the flow channel 40 mirror-symmetrically to the acoustic wave stimulator 30 shown in Fig. 1a, Fig. 1b.

In other words, the apparatus according to the non-depicted modified embodiment comprises an additional piezoelectric material 10a similar to the piezoelectric material 10 described in the context of the other embodiments, an additional interdigitated electrode region 20a similar to the interdigitated electrode region 20 described in the context of the other embodiments, an additional pair of electrodes 22a similar to the pair of electrodes 22 described in the context of the other embodiments, and an additional acoustic wave stimulator 30a similar to the acoustic wave stimulator 30 described in the context of the other embodiments. However, instead of being arranged above the piezoelectric material 10, the electrodes of the additional pair of electrodes 22a are arranged below the additional piezoelectric material 10a. The electrodes of the additional pair of electrodes 22a are horizontally interdigitated in the additional interdigitated electrode region 20a (rather than in the interdigitated electrode region 20). The additional acoustic wave stimulator 30a is adapted to stimulate an additional acoustic wave when excited via said additional pair of electrodes 22a with an additional electrical excitation having an additional single frequency, the additional acoustic wave stimulator 30a comprising at least a portion of the interdigitated additional electrodes 26a in the additional interdigitated electrode region 20a, and further comprising at least a portion of the additional piezoelectric material 10a, said at least portion of the piezoelectric material 10 overlying said at least portion of the interdigitated additional electrodes 22a in the additional interdigitated electrode region 20a. The additional acoustic wave stimulator 30a has an extension along the horizontal direction y perpendicular to the flow direction 44, z. According to a vertical projection onto the horizontal y-z plane, said extension of the additional acoustic wave stimulator 30a is fully comprised in said extension of the contiguous inner volume 42 of the flow channel 40.

To produce the non-depicted modified embodiment, the additional piezoelectric material 10a and the additional pair of electrodes 22a are provided to form the additional acoustic wave stimulator 30a as similarly described for the formation of the acoustic wave stimulator 30 using the piezoelectric material 10 and the pair of electrodes 22. The additional acoustic wave stimulator 30a is orientated invertedly (i.e., with the pair or electrodes 22 below the piezoelectric material 10) as compared to the acoustic wave stimulator 30 and arranged with this orientation on the device 2 according to any of the depicted embodiments with this orientation (e.g., on or above the flow channel 40), such that according to the vertical projection onto the horizontal plane, the extension of the additional acoustic wave stimulator 30a is fully comprised in said extension of the contiguous inner volume 42 of the flow channel 40.

According to this non-depicted, modified embodiment, the acoustic wave stimulator 30 may be excited to apply and acoustic wave with an amplitude gradient, or a pressure gradient, respectively, having an x-component directed upward. The additional acoustic wave stimulator 30a may be excited to apply an acoustic wave with an amplitude gradient, or a pressure gradient, respectively, having an x-component directed downward. Thus, the modified embodiment gives full control over the direction of the x-component of the amplitude gradient, or of the pressure gradient, respectively.

Fig. 2a, Fig. 2b illustrate the acoustic wave stimulator 30 and the pair of electrodes 22 in more detail. For the sake of clarity, only the pair of electrodes 22 is depicted in Fig. 2a, Fig. 2b. However, it is clear that the piezoelectric material (although not depicted) is present under the pair of electrodes 22 to form the acoustic wave stimulator 30 as shown in Fig. 1a, Fig. 1b.

The acoustic wave stimulator 30 has a length L, a distance d between neighboring electrodes 22 and a pitch p.

The resonance frequency of the acoustic wave stimulator 30 depends on the composition and orientation of the piezoelectric material 10, and on the distance d and the pitch p of the interdigitated electrodes 26.

The shorter the distance d, the higher the resonance frequency.

Excitation of the acoustic wave using the acoustic wave stimulator 30 is particularly efficient when the frequency f of the electrical excitation, or of the periodically varying voltage, respectively, matches the resonance frequency. Excitation of the acoustic wave using the acoustic wave stimulator 30 is typically highly inefficient when the frequency f of the electrical excitation, or of the periodically varying voltage, is different from the resonance frequency, becoming even more inefficient as the difference between the frequency f and the resonance frequency increases.

Fig. 3a and Fig. 3b illustrate an apparatus 2 according to another embodiment of the invention. Similar components are indicated with identical reference numerals. For the sake of brevity, they will not be described again, but reference is made to the corresponding detailed description above. The following description focuses on the modifications introduced in the embodiment of Fig. 3a and Fig. 3b.

The apparatus 2 according to the embodiment of Fig. 3a and Fig. 3b comprises an electrical excitation unit 52 adapted to provide the electrical excitation via the electrodes 22 to the acoustic wave stimulator 30.

For the sake of clarity of presentation, the electrical excitation unit 52 is depicted and described here in the context of Fig. 3a and Fig. 3b. Although not depicted, the electrical excitation unit 52 may as well be provided in the apparatus 2 according to any of the other embodiments.

In the depicted embodiment, the electrical excitation unit 52 is a waveform generator outputting a periodic voltage signal with a frequency f. In the depicted embodiment, the periodic voltage signal is a rectangular voltage signal, but other periodic voltage signals such as a sine-shaped periodic voltage signal may alternatively be applied.

In the embodiment of Fig. 3a and Fig. 3b, the distance d between the interdigitated electrodes 26 in the interdigitated electrode region 20 varies along said horizontal direction y.

More specifically, the distance d between the interdigitated electrodes 26 in the interdigitated electrode region 20 varies in a stepwise manner. In other words, neighboring interdigitated electrodes 26 in the interdigitated electrode region 20 have a first, constant distance d in a first section of the inner volume 42 of the flow channel 40 along the horizontal direction y. The neighboring interdigitated electrodes 26 in the interdigitated electrode region 20 have a second, constant distance d in a second section of the inner volume 42 of the flow channel 40 along the horizontal direction y. In the depicted embodiment, three respective sections of the inner volume 42 of the flow channel 40 along the horizontal direction y exist, but a smaller or larger number is possible.

In each of said sections, the interdigitated electrodes 26 together with the underlying piezoelectric material 10 define a different resonance frequency. In other words, different resonance frequencies are associated with said sections of the interdigitated electrodes 26.

When the electrical excitation unit 52 is operated such that the frequency f of the output periodic voltage signal matches the resonance frequency associated with one of said sections of the interdigitated electrodes 26, the respective section of the interdigitated electrodes 26 stimulates an acoustic wave. In other words, the respective section of the interdigitated electrodes 26, together with the underlying piezoelectric material 10, forms an acoustic wave stimulator 30 adapted to stimulate an acoustic wave when excited via the pair of electrodes 22 with an electrical excitation having a frequency f matching the resonance frequency associated with the respective section of the interdigitated electrodes 26.

This is illustrated in an exemplary manner in Fig. 3a and in Fig. 3b for two different frequencies f of the output periodic voltage signal from the electrical excitation unit 52, each matching the resonance frequency associated with one of the sections of the interdigitated electrodes 26.

In Fig. 3a, the frequency f of the output periodic voltage signal from the electrical excitation unit 52 matches the resonance frequency associated with the central section of the interdigitated electrodes 26 and the underlying piezoelectric material 10. The respective section of the interdigitated electrodes 26 and the underlying piezoelectric material 10 stimulate an acoustic wave, or they act as an acoustic wave stimulator 30, respectively. The other sections of the interdigitated electrodes 26 do not stimulate an acoustic wave, or they do not act as an acoustic wave stimulator 30, respectively.

In Fig. 3b, the frequency f of the output periodic voltage signal from the electrical excitation unit 52 matches the resonance frequency associated with the left section of the interdigitated electrodes 26 and the underlying piezoelectric material 10. The respective section of the interdigitated electrodes 26 and the underlying piezoelectric material 10 stimulate an acoustic wave, or they act as an acoustic wave stimulator 30, respectively. The other sections of the interdigitated electrodes 26 do not stimulate an acoustic wave, or they do not act as an acoustic wave stimulator 30, respectively.

The embodiment of Fig. 3a and Fig. 3b thus provides a plurality of acoustic wave stimulators 30, using a single interdigitated electrode region 20. The use of a plurality of acoustic wave stimulators 30 allows for sculpting the flows of the liquids 58a, 58b, 58c in the flow channel 40 with higher accuracy and to greater detail.

In Fig. 3a, Fig. 3b a line 50 is indicated. With respect to a cross section with respect to a vertical x-y plane intersecting Fig. 3a, Fig. 3b at the position indicated by line 50, the apparatus 2 of the embodiment of Fig. 3a, Fig. 3b looks as schematically illustrated in Fig. 1a. Regarding a detailed description of the apparatus 2 of the embodiment of Fig. 3a, Fig. 3b with respect to the respective cross section, reference is made to Fig. 1a above.

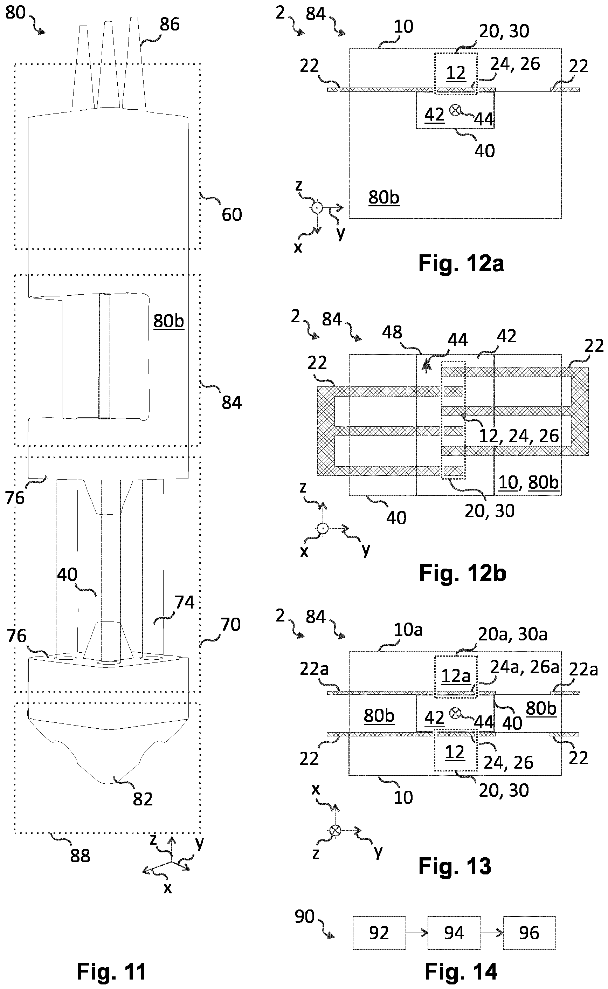

According to some embodiments (not depicted), the apparatus 2 according to the embodiment of Fig. 3a, Fig. 3b is formed with the additional acoustic wave stimulator 30a described in detail above in the context of the non-depicted modification of the apparatus 2 according to the first embodiment as well as in the context of the embodiment of Fig. 13.

Fig. 4a and Fig. 4b illustrate an apparatus 2 according to an embodiment of the invention similar to the embodiment of Fig. 3a and Fig. 3b. Similar components are indicated with identical reference numerals. For the sake of brevity, they will not be described again, but reference is made to the corresponding detailed description above. The following description focuses on the modifications introduced in the embodiment of Fig. 4a and Fig. 4b.

Like in the embodiment of Fig. 3a and Fig. 3b, in the apparatus 2 according to the embodiment of Fig. 4a and Fig. 4b, the distance d between the interdigitated electrodes 26 in the interdigitated electrode region 20 varies along said horizontal direction y.

However, in the embodiment of Fig. 4a and Fig. 4b, the distance d between the interdigitated electrodes 26 in the interdigitated electrode region 20 varies continuously along the horizontal direction y.

Hence, the resonance frequency associated with the interdigitated electrodes 26 (and the underlying piezoelectric material 10) in the interdigitated electrode region 20 varies continuously along the horizontal direction y.

Hence, when an electrical excitation having a single frequency is applied to the electrodes 22, the specific part of the interdigitated electrodes 26 for which the single frequency matches the resonance frequency associated with said specific part of the interdigitated electrodes 26 stimulates an acoustic wave. In other words, this specific part of the interdigitated electrodes 26 acts as an acoustic wave stimulator 30 adapted to stimulate an acoustic wave when excited via said pair of electrodes 22 with an electrical excitation having a single frequency.

According to some embodiments, said electrical excitation is provided by the electrical excitation unit 52 described above (electrical excitation unit not shown in Fig. 4a, Fig. 4b).

The excitation of a specific part of the interdigitated electrodes 26 is illustrated in an exemplary manner for two different frequencies f of the electric excitation, each of said frequencies f matching the resonance frequency associated with another part of the interdigitated electrodes 26.

In Fig. 4a, the frequency f matches the resonance frequency associated with the central part of the interdigitated electrodes 26 and the underlying piezoelectric material 10. The respective part of the interdigitated electrodes 26 and the underlying piezoelectric material 10 stimulate an acoustic wave, or they act as an acoustic wave stimulator 30, respectively. The other parts of the interdigitated electrodes 26 do not stimulate an acoustic wave, or they do not act as an acoustic wave stimulator 30, respectively.

In Fig. 4b, the frequency f matches the resonance frequency associated with the left part of the interdigitated electrodes 26 and the underlying piezoelectric material 10. The respective part of the interdigitated electrodes 26 and the underlying piezoelectric material 10 stimulate an acoustic wave, or they act as an acoustic wave stimulator 30, respectively. The other parts of the interdigitated electrodes 26 do not stimulate an acoustic wave, or they do not act as an acoustic wave stimulator 30, respectively.

By providing an electrical excitation with a frequency spectrum containing several frequencies f, several parts of the interdigitated electrodes 26 and the underlying piezoelectric material 10 can be excited simultaneously. For example, by providing an electrical excitation comprising both a first frequency matching the resonance frequency associated with the left part of the interdigitated electrodes 26 and a second frequency matching the resonance frequency associated with the right part of the interdigitated electrodes 26, the left part of the interdigitated electrodes 26 and the right part of the interdigitated electrodes 26 can be excited simultaneously (not depicted).

Correspondingly, an electrical excitation with a frequency spectrum containing several frequencies f can be used to excite multiple sections of the interdigitated electrodes 26 of Fig. 3a, Fig. 3b simultaneously, for example, to excite the left section of the interdigitated electrodes 26 and the right section of the interdigitated electrodes 26 simultaneously (not shown).

In Fig. 4a, Fig. 4b a line 50 is indicated. With respect to a cross section with respect to a vertical x-y plane intersecting Fig. 4a, Fig. 4b at the position indicated by line 50, the apparatus 2 of the embodiment of Fig. 4a, Fig. 4b looks as schematically illustrated in Fig. 1a. Regarding a detailed description of the apparatus 2 of the embodiment of Fig. 4a, Fig. 4b with respect to the respective cross section, reference is made to Fig. 1a above.

According to some embodiments (not depicted), the apparatus 2 according to the embodiment of Fig. 4a, Fig. 4b is formed with the additional acoustic wave stimulator 30a described in detail above in the context of the non-depicted modification of the apparatus 2 according to the first embodiment as well as in the context of the embodiment of Fig. 13.

Fig. 5a, Fig. 5b and Fig. 5c show cross sections through the inner volume 42 of the flow channel 40, or through the flows of the liquids 58a, 58b, 58c in the flow channel 40, respectively.

The planes 52, 54, 58 to which the cross sections of Fig. 5a, Fig. 5b and Fig. 5c refer, are vertical x-y planes at the positions 52, 54, 58 indicated in Fig. 4a, i.e., at the beginning, in the middle, and at the end of the acoustic wave stimulator 30, with respect to the flow direction 44, z. Although the cross sections are illustrated for the respective positions 52, 54, 58 with reference to the apparatus 2 according to the embodiment of Fig. 4a, similar cross sections can be achieved with the apparatus 2 according to any of the other embodiments.

Fig. 5a shows the flows of the liquids 58a, 58b, 58c prior to the flow sculpting using the acoustic wave stimulator 30. In the depicted embodiment, the flows of the liquids 58a, 58b, 58c are provided as parallel flows with the liquids 58a, 58b, 58c vertically stacked above one another. Alternative cross sections of the initial, parallel flows of the liquids 58a, 58b, 58c are possible.

Fig. 5b shows the flows of the liquids 58a, 58b, 58c undergoing the flow sculpting using the acoustic wave stimulator 30. Above the acoustic wave stimulator 30, the gradient of the amplitude of the acoustic wave, or of the pressure, respectively, is the largest, and it is directed upwards. Consequently, the force onto the liquids 58a, 58b, 58c, which is determined by said gradient, is the largest and is upwards-directed above the acoustic wave stimulator 30. The flows of the liquids 58a, 58b, 58c above the acoustic wave stimulator 30 are thus deflected upwards. Consequently, in the side regions of the inner volume 42 of the flow channel 40, the flows of the liquids 58a, 58b, 58c are deflected downwards. This may be understood when considering the amount of the liquids 58a, 58b, 58c flowing into and out of the upper half of the inner volume 42 of the flow channel 40. The respective contributions are necessarily balanced, without any net flow into or out of the upper half of the inner volume 42 of the flow channel 40. Since the liquids 58a, 58b, 58c flow into the upper half of the inner volume 42 of the flow channel 40 in its center (with respect to the horizontal direction y), the liquids 58a, 58b, 58c need to flow out of the upper half of the inner volume 42 of the flow channel 40 into the lower half of the inner volume 42 of the flow channel 40 at the sides of the flow channel 40.

Consequently, the flows of the liquids 58a, 58b, 58c bend to form a cross-section corresponding to the cross-section of a fiber having its principal direction along the flow direction 44, z.

As shown in Fig. 5c, the bending of the flows of the liquids 58a, 58b, 58c is finished at the end of the acoustic wave stimulator 30. This is achieved by a proper selection of the amplitude of the electrical excitation.

Fig. 6a and Fig. 6b illustrate an apparatus 2 according to two further embodiments of the invention. Similar components are indicated with identical reference numerals. For the sake of brevity, they will not be described again, but reference is made to the corresponding detailed description above. The following description focuses on the modifications introduced in the embodiments of Fig. 6a and Fig. 6b.

The apparatus 2 according to the embodiment of Fig. 6a and the apparatus 2 according to the embodiment of Fig. 6b are formed with an intermediate element 54 arranged between the piezoelectric material 10 and the flow channel 40. The shape of the intermediate element 54 varies in detail between the two embodiments of Fig. 6a and Fig. 6b.

The intermediate element 54 serves as a mechanical support for the channel 40 on the rest of the apparatus 2.

The intermediate element 54 further serves to improve adhesion of the channel 40 to the rest of the apparatus 2.

In the depicted embodiments, the intermediate element 54 is made from polydimethylsiloxane. This is particularly beneficial to promote adhesion of the channel 40 to the rest of the apparatus 2, in particular in embodiments wherein the channel 40 is at least in part made from polydimethylsiloxane.

According to some embodiments, the intermediate element 54 is a thin, continuous layer.

According to some embodiments, the intermediate element 54 forms the bottom wall of the channel walls.

According to some embodiments, the intermediate element 54 is located below only part of the channel 40, for example under those sections of the channel 40, where the acoustic wave stimulator 30 is not formed.

In alternative embodiments, the intermediate element 54 is formed as a layer between the channel 40 and the acoustic wave stimulator 30.

In alternative embodiments, the intermediate element 54 has a smaller thickness between the acoustic wave stimulator 30 and the channel 40 than under sections of the channel 40 not overlying the acoustic wave stimulator 30.

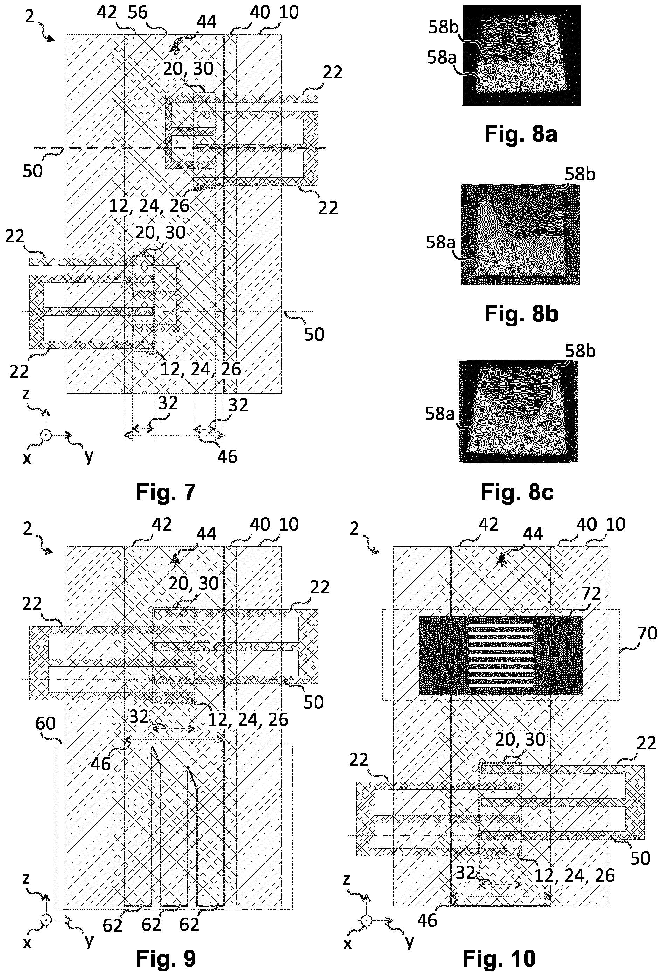

Fig. 7 illustrates an apparatus 2 according to an embodiment similar to the embodiment of Fig. 1a and Fig. 1b. Similar components are indicated with identical reference numerals. For the sake of brevity, they will not be described again, but reference is made to the corresponding detailed description above. The following description focuses on the modifications introduced in the embodiment of Fig. 7.

As compared to the embodiment of Fig. 1a and Fig. 1b, the apparatus 2 according to the embodiment of Fig. 7 comprises a plurality of acoustic wave stimulators 30 arranged at different positions with respect to said horizontal direction y.

This arrangement of acoustic wave stimulators 30 permits to generate gradients of the acoustic wave field, or of the pressure, respectively, directed towards the center of the inner volume 42 of the flow channel 40 from either side along the horizontal direction y. Without wishing to be bound by any theory, the applicant believes that the force onto the flows of the fluids for the channel 40 is proportionate to said gradient. Hence, the arrangement of the acoustic wave stimulators 30 according to the embodiment of Fig. 7 permits to generate forces directed towards the center of the inner volume 42 of the flow channel 40 from either side along the horizontal direction y. This further improves the flexibility regarding the shapes of the flows which can be sculpted with the apparatus 2.

More specifically, in the depicted embodiment, the left acoustic wave stimulator 30 is arranged to generate a gradient, or a force, respectively on the left-hand side of the channel 40. Said force is directed upwards and to the right.

The right acoustic wave stimulator 30 is arranged to generate a gradient, or a force, respectively on the right-hand side of the channel 40. Said force is directed upwards and to the left.

In the depicted embodiment, the acoustic wave stimulators 30 are arranged at different positions with respect to the flow direction 44, z. However, the position of the acoustic wave stimulators 30 with respect to the flow direction 44, z has a very minor influence on the sculpting of the flows. Thus, according to an alternative embodiment (not shown), the acoustic wave stimulators 30 are arranged at the same position with respect to the flow direction 44, z, giving similar effects.

Fig. 8a, Fig. 8b and Fig. 8c show cross sections through the inner volume 42 of the flow channel 40, or through the flows of the liquids 58a, 58b in the flow channel 40, respectively, at the outlet 56 of the flow channel 40 of Fig. 7.

For the sake of clarity, the outlet 56 of the flow channel 40 is indicated only in Fig. 7. However, it is clear that the apparatus 2 according to the other embodiments also each provide a respective outlet 56 of the flow channel 40 downstream of the acoustic wave stimulator 30.

The cross-section depicted in Fig. 8a has been experimentally measured with the right acoustic wave stimulator 30 of Fig. 7 being switched on, and the left acoustic wave stimulator 30 of Fig. 7 being switched off.

The cross-section depicted in Fig. 8b has been experimentally measured with the left acoustic wave stimulator 30 of Fig. 7 being switched on, and the right acoustic wave stimulator 30 of Fig. 7 being switched off.

The cross-section depicted in Fig. 8c has been experimentally measured with both acoustic wave stimulators 30 of Fig. 7 being switched on.

As Fig. 8a, Fig. 8b and Fig. 8c demonstrate, the influences of the acoustic wave stimulators 30 on the flows of the liquids 58a, 58b add up in an approximately linear manner. Consequently, almost arbitrary shapes of the sculpted flows of the liquids 58a, 58b can be generated by positioning acoustic wave stimulators 30 at adequate positions along the flow channel 40.

Fig. 9 illustrates an apparatus 2 according to another embodiment of the invention. Similar components are indicated with identical reference numerals. For the sake of brevity, they will not be described again, but reference is made to the corresponding detailed description above. The following description focuses on the modifications introduced in the embodiment of Fig. 9.

The apparatus 2 according to this embodiment comprises a parallel flow generator 60. The parallel flow generator 60 comprises additional flow channels 62, each fluid-connected to the main flow channel 40 upstream of the acoustic wave stimulator 30. The additional flow channels 62 are adapted to provide corresponding flows of liquids 58a, 58b, 58c to the main flow channel 40, ensuring that the flows are hydrodynamically focused into the main flow channel 40. This configuration allows for the generation of parallel flows of liquids 58a, 58b, 58c in the main flow channel 40, which can then be sculpted by the acoustic wave stimulator 30.

Apart from the parallel flow generator 60, Fig. 9 shows an embodiment of the apparatus 2 similar to the embodiment of Fig. 1a, Fig. 1b. However, the provision of a parallel flow generator 60 is not limited to such embodiment. According to different embodiments, the parallel flow generator 60 is provided with the apparatus 2 described in the context of any of the other figures.

Fig. 10 illustrates an apparatus 2 according to another embodiment of the invention. Similar components are indicated with identical reference numerals. For the sake of brevity, they will not be described again, but reference is made to the corresponding detailed description above. The following description focuses on the modifications introduced in the embodiment of Fig. 10.

The apparatus 2 according to the embodiment of Fig. 10 comprises a lithographic mask 72 arranged in a lithographic masking section 70 of the apparatus 2. The lithographic masking section 70 is positioned downstream of the acoustic wave stimulator 30, and a section of the flow channel 40 passes through this lithographic masking section 70. The lithographic mask 72 is arranged such that, under illumination with UV radiation directed towards the center of the flow channel section, the UV radiation is masked before reaching the section of the flow channel 40 passing through the lithographic masking section 70.

Optionally, the apparatus 2 comprises a UV source (not shown) adapted to shine said UV radiation onto the mask 72 and partly therethrough onto the channel 40.

Respective embodiments permit to cure at least one UV hardening chemical component comprised in at least one of the liquids 58a, 58b, 58c of the flows.

Apart from the lithographic mask 72 and the optional UV source, Fig. 10 shows an embodiment of the apparatus 2 similar to the embodiment of Fig. 1a, Fig. 1b. However, the provision of the lithographic mask 72 and the optional UV source is not limited to such embodiment. According to different embodiments, the lithographic mask 72 and the optional UV source is/are provided with the apparatus 2 described in the context of any of the other figures.

Figure 11 illustrates a print head 80 for 3D printing.

The print head 80 comprises various sections 60, 84, 70, and 88.

According to some embodiments, one or any of the sections 60, 84, 70, 88 is provided separate from a neighboring one of the sections 60, 84, 70, 88 and with means for a detachable, waterproof connection to said neighboring one of the sections 60, 84, 70, 88. The detachable, waterproof connection is implemented with o-rings and fastening means, the fastening means mechanically clamping the section 60, 84, 70, 88 and the neighboring section 60, 84, 70, 88 to each other such that the o-ring is clamped between the section 60, 84, 70, 88 and the neighboring section 60, 84, 70, 88 to implement a continuous, liquid-tight channel through the section 60, 84, 70, 88 and the neighboring section 60, 84, 70, 88, for example with the o-ring encircling said continuous, liquid-tight channel.

The print head 80 comprises a body 80b. The body is formed from a metal or from a polymer.

According to some embodiments, the body 80b is an integral piece.

The print head 80 comprises a flow-sculpting section 84. According to different embodiments, the flow-sculpting section 84 is similar to the apparatus 2 according to any of the embodiments of Fig. 1a, Fig. 1b, Fig. 3a, Fig. 3b, Fig. 4a, Fig. 4b, Fig. 6a, Fig. 6b or Fig. 7.

According to an embodiment, the parallel-flow providing section 60 of the print-head 80 is similar to the parallel flow generator 60 of Fig. 9.

The parallel-flow providing section 60 is provided with inlets 86 for the fluids.

According to an embodiment, the lithography section 70 of the print-head 80 is similar to the lithographic masking section 70 of Fig. 9.

The lithography section 70 is provided with rigid end sections 76 and with mechanical support structures 74 connecting the rigid end sections 76. The flow channel 40 spans between the rigid end sections 76, the rigid end sections 76 mechanically supporting the flow channel 40. Respective embodiments permit the usage of a flow channel 40 comprising or composed of a flexible material, such as polydimethylsiloxane. Polydimethylsiloxane further has the advantage of being oxygen permeable, with the advantages described above.

The output section 88 is provided with an outlet nozzle 82.

An outlet of the flow channel 40 is fluid-connected to said outlet nozzle 82 of the print head 80, such that the print head 80 is adapted to provide at its outlet nozzle 82 the output of said outlet of the flow channel 40.

Fig. 12a and Fig. 12b illustrate an apparatus 2 according to another embodiment of the invention. Similar components are indicated with identical reference numerals. For the sake of brevity, they will not be described again, but reference is made to the corresponding detailed description above. The following description focuses on the modifications introduced in the embodiment of Fig. 12a and Fig. 12b.

The apparatus 2 according to the embodiment of Fig. 12a and Fig. 12b is particularly well-suited for the use as a flow-sculpting section 84 of a print head 80.

Fig. 12a shows a cross section of the apparatus 2 in a plane perpendicular to the flow direction 44, z. Notably, in Fig. 12a, for the sake of clarity of presentation, the overall apparatus (and also the coordinate system) have been turned upside down for better clarity, such that the positive vertical direction +x points downwards.

A channel substrate 80b, which, according to some embodiments, is provided by the body 80b of the print head 80, has a cross section corresponding to an inverted U. In other words, the channel substrate 80b, or the body 80b of the print head 80, respectively, is formed with an elongated recess.

The piezoelectric material 10 and the electrodes 22 thereon are initially provided separately from the rest of the apparatus 2, as described above in the context of the embodiment of Fig. 1a, Fig. 1b, or separately from the print head 80, respectively.

Said piezoelectric material 10 and electrodes 22 are then placed from below on the channel substrate 80b, or on the body 80b of the print head 80, respectively, or on the recess, respectively, to complete the flow channel 40, i.e., to make it fluid-tight. Fastening means to press the piezoelectric material 10 and electrodes 22 onto the channel substrate 80b, or onto the body 80b of the print head 80, respectively, are provided for this purpose.

Fig. 12b shows a projection of the resulting arrangement onto the y-z plane.

Fig. 13 illustrates an apparatus 2 according to an embodiment similar to the embodiments described above. Similar components are indicated with identical reference numerals. For the sake of brevity, they will not be described again, but reference is made to the corresponding detailed description above. The following description focuses on the modifications introduced in the embodiment of Fig. 13.

As compared to the foregoing embodiments, the apparatus 2 according to the embodiment of Fig. 13 is formed with an additional acoustic wave stimulator 30a, an additional piezoelectric material 10a, an additional interdigitated electrode region 20a, and an additional pair of electrodes 22a being horizontally interdigitated in the additional interdigitated electrode region 20a. The additional acoustic wave stimulator 30a comprises at least a portion 24a of the additional interdigitated electrodes 26a in the additional interdigitated electrode region 20a, and further comprises at least a portion 12a of the additional piezoelectric material 10a, said at least one portion 12a of the additional piezoelectric material 10a overlying said at least one portion 24a of the interdigitated electrodes 26a in the additional interdigitated electrode region 20a. The similarity between the additional acoustic wave stimulator 30a and the acoustic wave stimulator 30 has been described in further detail above. The respective description applies as well to the embodiment of Fig. 13. In particular, the extension of the additional acoustic wave stimulator 30a along the horizontal direction y perpendicular to the flow direction 44, z is fully comprised in the extension 46 of the contiguous inner volume 42 of the flow channel 40.

In other words, the additional acoustic wave stimulator 30a is similar to the acoustic wave stimulator 30, but with all vertical orientations and arrangements inverted.

The additional acoustic wave stimulator 30a is depicted in the context of the embodiment of Fig. 13. According to different embodiments, the apparatus 2 according to any of the foregoing embodiments is formed with said additional acoustic wave stimulator 30a.

According to alternative embodiments (not shown), further IDTs are provided on the channel side walls, i.e. on the side walls of the flow channel 40 (which are, the left side wall of the flow channel 40 and the right side wall of the flow channel 40), i.e., on the flow channel 40 to the left and to the right of the flow channel 40 along the horizontal direction y.

Fig. 14 illustrates a method 90 for flow sculpting. The method comprises, at step 92, providing the apparatus 2 or the print head 80 according to any of the embodiments described above. The method comprises, at step 94, providing the flows of the liquids 58a, 58b, 58c in the flow channel 40 of the apparatus 2 or of the print head 80 as parallel flows of fluids upstream of the acoustic wave stimulator 30. The method comprises, at step 96, applying an electrical excitation to the acoustic wave stimulator 30 via the pair of electrodes 22 to stimulate the acoustic wave, thus sculpting the flows of the fluids in the flow channel 40.

The examples of the present disclosure disclosed herein only constitute specific examples for illustration purposes. The present invention can be implemented in various ways and with many modifications without altering the underlying basic properties. Therefore, the present invention is only defined by the claims as stated below.

## Claims

1. An apparatus (2) for sculpting flows of liquids (58a, 58b, 58c) in a flow channel (40), the apparatus (2) comprising:
a piezoelectric material (10);
an interdigitated electrode region (20);
a pair of electrodes (22), said electrodes (22) being arranged above the piezoelectric material (10) and being horizontally interdigitated in the interdigitated electrode region (20);
an acoustic wave stimulator (30), said acoustic wave stimulator (30) being adapted to stimulate an acoustic wave when excited via said pair of electrodes (22) with an electrical excitation having a single frequency (f), the acoustic wave stimulator (30) comprising at least a portion (24) of the interdigitated electrodes (26) in the interdigitated electrode region (20), and further comprising at least a portion (12) of the piezoelectric material (10), said at least portion (12) of the piezoelectric material (10) underlying said at least portion (24) of the interdigitated electrodes (26) in the interdigitated electrode region (20);
the flow channel (40), said flow channel (40) being arranged above the interdigitated electrode region (20), said flow channel (40) defining a contiguous inner volume (42) thereof and a flow direction (44, z) for the flows of the liquids (58a, 58b, 58c) in the flow channel (40);
wherein the acoustic wave stimulator (30) has an extension (32) along a horizontal direction (y), said horizontal direction being perpendicular to the flow direction (44, z);
wherein the contiguous inner volume (42) of the flow channel (40) has an extension (46) along said horizontal direction; and
wherein, according to a vertical projection onto a horizontal plane (y-z), said extension (32) of the acoustic wave stimulator (30) is fully comprised in said extension (46) of the contiguous inner volume (42) of the flow channel (40).

2. The apparatus (2) according to claim 1,
wherein the flow channel (40) comprises opposite side walls separating the contiguous inner volume (42) of the flow channel (40) from an outside of the flow channel (40); and
wherein the contiguous inner volume (42) of the flow channel (40) extends continuously from one of said opposite side walls to an opposite one of said opposite side walls, in particular without any flow obstacle in between;
wherein, optionally, the contiguous inner volume (42) of the flow channel (40) has said extension (46) from one of the opposite side walls to the opposite one of the opposite side walls in a vertical plane perpendicular to the flow direction (44, z), preferably in a plurality of vertical planes perpendicular to the flow direction (44, z), said vertical planes being spaced apart along the flow direction (44, z) from each other by a distance exceeding said extension (32) of the acoustic wave stimulator (30) or exceeding said extension (46) of the contiguous inner volume (42) of the flow channel (40).

3. The apparatus (2) according to claim 1 or claim 2, wherein a total length of the acoustic wave stimulator (30) along the flow direction (44, z) is at least as large as the extension (32) of the acoustic wave stimulator (30) along said horizontal direction or wherein a total length of the acoustic wave stimulator (30) along the flow direction is at least three times or at least five times as large as the extension (32) of the acoustic wave stimulator (30) along said horizontal direction,
in particular, wherein
the total length refers to the length along the flow direction (44, z) of a single acoustic wave stimulator (30) according to claim 1 or the apparatus (2) comprises a plurality of respective acoustic wave stimulators (30), and the total length refers to the sum of the lengths of said acoustic wave stimulators (30) along the flow direction (44, z), in particular wherein the acoustic wave stimulators (30) of the plurality of respective acoustic wave stimulators (30) are located at different positions along the flow direction (44, z).

4. The apparatus (2) according to any of the preceding claims, further comprising an electrical excitation unit (52) adapted to provide said electrical excitation via the electrodes (22) to the acoustic wave stimulator (30) to drive the acoustic wave stimulator (30) to stimulate said acoustic wave,
wherein, optionally, the electrical excitation unit (52) is adapted to provide the electrical excitation with a varying amplitude, such that, as the flows of the liquids (58a, 58b, 58c) in the flow channel (40) pass flowing above the acoustic wave stimulator (30), they are exposed to said acoustic wave while the acoustic wave has a varying amplitude, in particular a time-varying amplitude and/or a spatially varying amplitude, in particular a spatially varying amplitude as a sub-volume of the flows of the liquids (58a, 58b, 58c) in the flow channel (40) passes flowing above the acoustic wave stimulator (30) along the flow direction (44, z).

5. The apparatus (2) according to any of the preceding claims, further comprising an intermediate element (54) arranged between the piezoelectric material (10) and the flow channel (40),
wherein, optionally,
the intermediate element (54) is adapted to, in particular arranged to and/or shaped to, mechanically support a section of the flow channel (40) not arranged directly above the interdigitated electrode region (20); and/or
the intermediate element (54) has a larger thickness along the vertical direction at a position not directly above the interdigitated electrodes (26) in the interdigitated electrode region (20) than above the interdigitated electrodes (26) in the interdigitated electrode region (20), in particular, including a thickness of zero, or an absence, respectively, of the intermediate element (54) above the interdigitated electrodes (26) in the interdigitated electrode region (20); and/or
wherein the intermediate element (54) is arranged at a larger distance from a vertical plane extending along the flow direction (44, z) through a center of the flow channel (40) than the interdigitated electrode region (20); and/or wherein the intermediate element (54) is an adhesion layer to promote adhesion of the flow channel (40) to another component of the apparatus (2), in particular to the piezoelectric material (10) and/or to the acoustic wave stimulator (30); and/or
wherein the intermediate element (54) is an intermediate layer; and/or
wherein the intermediate element (54) comprises or is composed of a polymer.

6. The apparatus (2) according to any of the preceding claims,
wherein the acoustic wave stimulated by the acoustic wave stimulator (30) is a surface acoustic wave, in particular on a surface of the acoustic wave stimulator (30) and/or on an inner surface of the flow channel (40); and/or
wherein the flows of liquids (58a, 58b, 58c) in the flow channel (40) are parallel flows of liquids (58a, 58b, 58c) in the flow channel (40); and/or
wherein the electrodes (22) of the pair of electrodes (22) being horizontally interdigitated refer to each electrode of the pair of electrodes (22) comprising or being finger electrodes, wherein a vertical plane parallel to the flow direction (44, z) intersects each of said finger electrodes of each of the electrodes (22) of the pair of electrodes (22) and/or wherein a line parallel to the flow direction (44, z) intersects each of said finger electrodes of each of the electrodes (22) of the pair of electrodes (22); and/or
wherein the electrodes (22) of the pair of electrodes (22) are electrically connected and/or directly connected to the piezoelectric material (10) in the interdigitated electrode region (20); and/or
wherein for each electrode of the pair of electrodes (22) a vertical reference line exists intersecting both the piezoelectric material (10) and the respective electrode of the pair of electrodes (22); and/or
wherein the electrodes (22) comprise or consist of an electrically conductive material, in particular of a metal; and/or
wherein the single frequency (f) is in a range from 1 MHz to 1 GHz; and/or
wherein the electrodes (22) in the interdigitated electrode region (20) extend along a horizontal plane and/or are all intersected by a single horizontal plane; and/or
wherein the vertical projection refers to a projection along the vertical direction.

7. The apparatus (2) according to any of the preceding claims, wherein each electrode of the pair of electrodes (22) comprises finger electrodes, the finger electrodes of both of the electrodes (22) of the pair of electrodes (22) being parallel in the interdigitated electrode region (20);
in particular, wherein the finger electrodes form the interdigitated electrodes (26) in the interdigitated electrode region (20); and/or
wherein the finger electrodes are spaced equidistantly along said horizontal direction; and/or
wherein the finger electrodes of the electrodes (22) of the pair of electrodes (22) are arranged alternatingly along said horizontal direction, in particular such that for each finger electrode of one of the electrodes (22) of the pair of electrodes (22) at least one neighboring finger electrode exists, the neighboring finger electrode being a finger electrode of the other electrode of the pair of electrodes (22).

8. The apparatus (2) according to claim 7, comprising
a plurality of interdigitated electrode regions (20) comprising said interdigitated electrode region (20), each interdigitated electrode region (20) of the plurality of interdigitated electrode regions (20) being an interdigitated electrode region (20) according to claim 7;
a plurality of pairs of electrodes (22) comprising said pair of electrodes (22), each pair of electrodes (22) from the plurality of pairs of electrodes (22) associated with a corresponding interdigitated electrode region (20) from the plurality of interdigitated electrode regions (20), the electrodes (22) of each pair of electrodes (22) being arranged above the piezoelectric material (10) and being horizontally interdigitated in the associated interdigitated electrode region (20); and
a plurality of acoustic wave stimulators (30) comprising said acoustic wave stimulator (30), each of said acoustic wave stimulators (30) associated with a corresponding interdigitated electrode region (20) and with the pair of electrodes (22) associated with the respective associated interdigitated electrode region (20), each of said acoustic wave stimulators (30) being adapted to stimulate an acoustic wave when excited via the associated pair of electrodes (22) with an electrical excitation having a single frequency (f), each of the acoustic wave stimulators (30) comprising at least a portion of the interdigitated electrodes (26) of the associated pair of electrodes (22) in the associated interdigitated electrode region (20), and further comprising at least a portion of the piezoelectric material (10), said at least one portion of the piezoelectric material (10) underlying said at least one portion of the interdigitated electrodes (26) of the associated pair of electrodes (22) in the associated interdigitated electrode region (20);
wherein, according to a vertical projection onto a horizontal plane, an extension (32) of each of the acoustic wave stimulators (30) is fully comprised in said extension (46) of the contiguous inner volume (42) of the flow channel (40); and
wherein the interdigitated electrode regions (20) of the plurality of interdigitated electrode regions (20) are arranged at different positions with respect to said horizontal direction.

9. The apparatus (2) according to any of claims 1 to 6, wherein a distance (d) between the interdigitated electrodes (26) in the interdigitated electrode region (20) varies along said horizontal direction;
wherein, optionally
each electrode of the pair of electrodes (22) comprises finger electrodes, the finger electrodes of one of the electrodes (22) of the pair of electrodes (22) forming the interdigitated electrodes (26) in the interdigitated electrode region (20) together with the finger electrodes of the other electrode of the pair of electrodes (22), in particular, wherein the distance (d) between the interdigitated electrodes (26) in the interdigitated electrode region (20) refers to a distance (d) between the finger electrodes of one of the electrodes (22) of the pair of electrodes (22) and the finger electrodes of the other electrode of the pair of electrodes (22); and/or
the distance (d) between the interdigitated electrodes (26) in the interdigitated electrode region (20) varies monotonically along said horizontal direction; and/or
the distance (d) between the interdigitated electrodes (26) in the interdigitated electrode region (20) varies along said horizontal direction in a stepwise manner or continuously.

10. The apparatus (2) according to claim 1, further comprising a parallel flow generator (60) adapted to provide the flows of liquids (58a, 58b, 58c) in the flow channel (40) as parallel flows of liquids (58a, 58b, 58c), the parallel flow generator (60) comprising additional flow channels (62), each of said additional flow channels (62) fluid-connected to the flow channel (40) upstream of the acoustic wave stimulator (30),
wherein, optionally,
each of said additional flow channels (62) is adapted to provide a corresponding one of the flows of the liquids (58a, 58b, 58c) to the flow channel (40); and/or
the additional flow channels (62) are fluid-connected to the flow channel (40) upstream of the acoustic wave stimulator (30) such that flows of fluids provided to the flow channel (40) from the additional flow channels (62) are hydrodynamically focused into the flow channel (40); and/or
wherein the parallel flows of liquids (58a, 58b, 58c) are stacked vertically above one another or are at least in part stacked vertically above one another; and/or
wherein the parallel flows of liquids (58a, 58b, 58c) are stacked side by side to each other along said horizontal direction, or are at least in part stacked side by side to each other along said horizontal direction.

11. The apparatus (2) according to any of the preceding claims, further comprising a lithographic mask (72) arranged in a lithographic masking section (70) of the apparatus (2), the lithographic masking section (70) arranged downstream of the acoustic wave stimulator (30);
wherein a section of the flow channel (40) passes through said lithographic masking section (70); and
wherein the lithographic mask (72) is arranged in the lithographic masking section (70) such that, under illumination of the lithographic mask with a UV radiation having a direction towards said section of the flow channel (40), said UV radiation is masked with the lithographic mask (72) before reaching said section of the flow channel (40);
in particular,
wherein at least one of the liquids (58a, 58b, 58c) comprises a chemical component suitable to be cured or hardened under illumination with UV radiation, or at least two of the liquids (58a, 58b, 58c) comprise respective chemical components suitable to be cured or hardened under illumination with UV radiation; and/or
wherein the lithographic mask (72) comprises slits having segments with an extension perpendicular to a flow direction in the lithographic masking section (70), said slits being adapted to allow said UV radiation to reach said section of the channel, wherein the lithographic mask (72) is adapted to block at least a part of the UV radiation or the UV radiation not passing through the slits; and/or
wherein the apparatus (2) further comprises a UV source adapted to provide said UV radiation having the direction towards the center of said section of the flow channel (40); and/or
wherein said section of the flow channel (40) is permeable to oxygen.

12. A print head (80) for 3D printing, the print head (80) comprising an outlet nozzle (82) and the apparatus (2) according to any of the preceding claims, wherein an outlet (48) of the flow channel (40) is fluid-connected to said outlet nozzle (82) of the print head (80), such that the print head (80) is adapted to provide at its outlet nozzle (82) the output of said outlet (48) of the flow channel (40).

13. A method (90) for flow sculpting, the method comprising:
providing (92) the apparatus (2) or the print head (80) according to any of the preceding claims,
providing (94) the flows of the liquids (58a, 58b, 58c) in the flow channel (40) of the apparatus (2) as parallel flows of fluids in the flow channel (40) upstream of the acoustic wave stimulator (30) of the apparatus (2); and
applying (96) an electrical excitation to the acoustic wave stimulator (30) via the pair of electrodes (22) to stimulate said acoustic wave, thus sculpting the flows of the fluids in the flow channel (40).

14. The method of claim 13,
wherein the fluids comprise a common solvent or the fluids are miscible, in particular, wherein the fluids are partially miscible or the fluids are fully miscible or the fluids are partially miscible co-flowing fluids with negligible interfacial tension; and/or
wherein providing the flows of the liquids (58a, 58b, 58c) in the flow channel (40) of the apparatus (2) as parallel flows of fluids in the flow channel (40) upstream of the acoustic wave stimulator (30) of the apparatus (2) comprises hydrodynamically focusing flows of liquids from additional flow channels (62) fluid-connected to the flow channel (40) upstream of the acoustic wave stimulator (30) into the flow channel (40).

15. The method of claim 13 or 14, wherein the electrical excitation is said electrical excitation having the single frequency (f),
wherein, when excited via said pair of electrodes (22) with the electrical excitation having said single frequency (f), only a portion (24) of the interdigitated electrodes (26) in the interdigitated electrode region (20) and the piezoelectric material (10) underlying said only portion (24) of the interdigitated electrodes (26) stimulates the acoustic wave, said only portion (24) of the interdigitated electrodes (26) in the interdigitated electrode region (20) having an extension (32) along said horizontal direction; and
wherein, according to a vertical projection onto a horizontal plane, said extension (32) of said only portion (24) of the interdigitated electrodes (26) in the interdigitated electrode region (20) is smaller than an extension of the interdigitated electrodes (26) in the interdigitated electrode region (20) along said horizontal direction, in particular at least by a factor of 1.5 or at least by a factor of 2.
